# EUROPEAN PATENT SPECIFICATION

(11) **EP 2 978 492 B1**
(45) Date of publication and mention of the grant of the patent: **19.02.2020**
(21) Application number: 14716012.1
(22) Date of filing: 05.03.2014
(51) Int. Cl.: A61N 2/00

(54) **METHOD AND APPARATUS FOR MONITORING THE PERSONAL EXPOSURE TO STATIC OR QUASI- STATIC MAGNETIC FIELDS**
VERFAHREN UND VORRICHTUNG ZUR ÜBERWACHUNG DER PERSÖNLICHEN EXPOSITION GEGENÜBER STATISCHEN ODER QUASI-STATISCHEN MAGNETFELDERN
PROCÉDÉ ET APPAREIL POUR SURVEILLER L'EXPOSITION PERSONNELLE À DES CHAMPS MAGNÉTIQUES STATIQUES OU QUASI-STATIQUES

(30) Priority: 29.03.2013 IT RM20130189
(43) Date of publication of application: 03.02.2016
(73) Proprietor: Universita' Degli Studi Dell'Aquila, 67100 Coppito L'Aquila (IT)
(72) Inventor: GALANTE, Angelo, 67100 L'Aquila (IT); PLACIDI, Giuseppe, I-67100 L'Aquila (IT)
(74) Representative: Romano, Giuseppe
(86) International application number: PCT/IB2014/059469
(87) International publication number: WO 2014/155215

(56) References cited:
- WO-A1-2012/032477
- US-A1- 2009 010 390
- US-B1- 6 169 963

## Description

### Background of the Invention

The present invention refers to an apparatus and a method for making an automatic "environmental" dosimeter, for environments characterized by the need for surveillance for purposes of protection of staff or visitors being admitted thereto, due to the presence of static or quasi-static magnetic fields.

In all advanced countries, regulations provide for surveillance (monitoring) of environments in which assigned staff and/or visitors may be exposed to values of static or variable low-frequency magnetic field exceeding certain thresholds. By way of non-exhaustive example, consider, e.g., medical-type instruments such as nuclear magnetic resonance (NMR) imaging apparatuses, industrial apparatuses providing the use of low-frequency magnetic fields or electric currents, magnets for operating particle accelerators and detectors, all research laboratories where the use of magnetic fields, however generated, be provided.

In case of quasi-static magnetic fields, of greater interest for the present invention, laws generally provide for the need for all staff having access to controlled areas to comply with preset magnetic field exposure limits (the latter depending both on field value and duration of exposure, and on the oscillation frequency of the field itself), and with limits on the induced currents that may be generated in the body following a variation of linked magnetic flow due to temporal variations of the field and/or following motions performed by staff inside the controlled area. Remarkably, regulations generally provide distinct limits for the various anatomical districts, specifying distinct threshold values at least in the case of head, torso and limbs.

### State of the Art

Measurement of static magnetic fields is generally performed with different devices, depending on the required dynamic range and maximum detectable value.

Some of these apparatuses are also capable of providing vector-type information, enabling a concomitant measurement of the three components of the magnetic field with respect to a triad of Cartesian axes with arbitrary orientation in space.

Relevant to the application field of the present invention are those systems having the feature of portability so as to be capable of following the operator in his/her motions, measuring the temporal variation of exposure. The instruments capable of performing one or more of the tasks set forth above were the object of some patents.

Among them, International Patent Application WO94/02863, for an instrument capable of measuring the three spatial components of the magnetic induction vector for static or quasi-static fields and develop a frequency analysis thereof;
International Patent Application WO02/082112, for a portable system capable of detecting the temporal variations of a magnetic field along three coordinate axes and, therefrom, trace currents induced on the exposed person;
International Patent Application WO06/034551, prefiguring portable instruments that put together triads of static field sensors and sensors based on the induction principle for the simultaneous measurement of the static field and its temporal variations in a wide dynamic range, with storage on non-volatile memory for later analysis of the data. Other relevant documents are WO 2012/032477, US6169963 and US2009/010390.

Moreover, there are also some commercial products, proposed for surveillance of operators assigned to MRI instruments. For instance, the TALETE® device by Tecnorad and the MaFiSS® device by Te.Si.a.. In both cases, it is a wearable personal dosimeter capable of measuring and recording on a non-volatile memory, for a later analysis stage, the module of the magnetic induction vector. In the case of MaFiSS the dynamic range is from 1G to 2000G, with a sampling frequency of about 0.2Hz.

However, the documentation cited hereto is based on the same operation principle, i.e. providing for the person to be monitored to wear a device that, with different modes, records magnetic field data in a given spatial point that moves integrally with the person him/herself.

Alternatively, numerical simulations were used to estimate exposure levels of medical and supporting staff employed in operations related to the operativeness of nuclear magnetic resonance (NMR) imaging scanners, working at different values of magnetic field. In connection with such alternative methods, it has been highlighted how, above all owing to motions by the staff, it is easy to exceed legal limits, above all with regard to values of magnetic field variation over time; this phenomenon becomes ever more worrisome with the increase of the value of magnetic field employed *[*Crozier S. and Liu F., "Numerical evaluation of the fields caused by body motion in or near high-field MRI scanners", Progress in Biophysics and Molecular Biology, 87: 267-278, 2005*, RR570 Research Report, "*Assessment of electromagnetic fields around magnetic resonance imaging (MRI) instruments", Prepared by MCL-T Ltd for the Health and Safety Executive 2007*].*

Therefore, the limitation of the state of the art for magnetic field dosimetry, for instance in an MRI scope, emerges clearly. Even when the instruments proposed is capable of performing field measurements in a wide dynamic range and measurements of variation of magnetic field over time, the limitation remains that such measurements are related to a single point of space, point moving integrally with the person being monitored and coinciding with the position of the sensors inside the portable measuring unit.

Actually, such instruments do not enable a complete control of exposure of the various anatomical districts (as instead provided for by the regulations, which generally draw a distinction at least among head, torso and limbs, setting distinct threshold values).

The above-highlighted limitation becomes even more stringent when considering the measurement of the variation of magnetic field over time. In this case, distinct body districts may be subject to distinct magnetic field values owing to their different position, and object of different values of electric currents induced following various types of motion. Suffice it to consider the case of a motion of rotation around the chest of a person whose arms be disposed horizontally to his/her feet-head axis - this is a situation typically seeing the upper limbs moving more than the torso and also doing it with higher speeds; or of a forward flexing of the chest, entailing a minimal displacement for a dosimeter connected at the waist (one of the typical positionings of portable systems is on a belt) but a great displacement of the head. The difference between what measured in a point of the body and what actually occurs in a distinct point is then amplified by the rapid spatial variability typically characterizing the scattered fields generated by apparatuses employing intense magnetic fields.

By way of example, let us report how the field generated by a modern NMR imaging system can, outside of the space dedicated to the patient, have consistent field gradients that may reach, in the immediate vicinity of the magnet, even values of the order of 1000 G/m.

Therefore, the differences among a simple point measurement and a specific measurement for each body district are not limited to the instantaneous field values detected, but also, following motion in a spatially non-uniform magnetic field, with the varying over time of the linked flow and therefore of the induced currents.

Hence, an object of present invention is to overcome the above-mentioned problems, and this is attained through a method for monitoring the exposure of one or more subjects to a magnetic field in an environment as defined in claim 1.

A further object of the present invention is to provide a system for monitoring the exposure of one or more subjects to a magnetic field in an environment as defined in claim 11.

An object of the present invention is to provide a method suitable for monitoring the exposure levels of staff that, for professional reasons or for any other reason, be accessing into environments characterized by static or quasi-static magnetic field values requiring a control.

The present invention, by overcoming the problems of the known art, entails numerous evident advantages.

In particular, the proposed system enables to obtain a measurement of the exposure to a magnetic field specific for the various body districts of one or more persons present in the environment in which there is a magnetic field, which may exceed preset threshold values.

Moreover, it enables to obtain, always specifically for each body district of each person present, a measurement of the variation rate of the linked magnetic field flow, due to motions of the persons themselves, a quantity the latter one which can be utilized in a computerized system for estimating the value of the currents induced in tissues.

The proposed system does not provide for the operator to wear a dosimeter on one or more specific body locations, thereby eliminating the chance of fault in the continuous surveillance due to negligence and/or oversight of the staff themselves. Moreover, the absence of sensors for field measurement allows to measure the quantities of interest without limits of dynamic range or of readiness related to the use of a physical sensor for the measurement of the field or of its temporal variations.

The present invention further allows to keep the control active also in environments hostile to electronic instruments, such as an MRI room. This applies also during the MRI data acquiring stage, during which the use of intense radiofrequency fields can limit the operation of many electronic apparatuses.

As to measurement, the invention allows to differentiate exposure by anatomical district and is not limited to measuring it for a particular point of the subject, to then assume it as valid average for the entire body.

The method provided allows to measure, for various body districts, not only the exposure to a magnetic field but also its temporal variation, and therefrom trace the values of current induced in tissues.

All this allows to improve surveillance effectiveness, also thanks to a system capable of sensing in real time the exceeding of predetermined threshold values (both with regard to field values and to those of induced currents) in order to comply with regulations.

These and other advantages, along with the features and the operation steps of the present invention, will be made evident in the following detailed description of preferred embodiments thereof, given by way of example and not for limitative purposes.

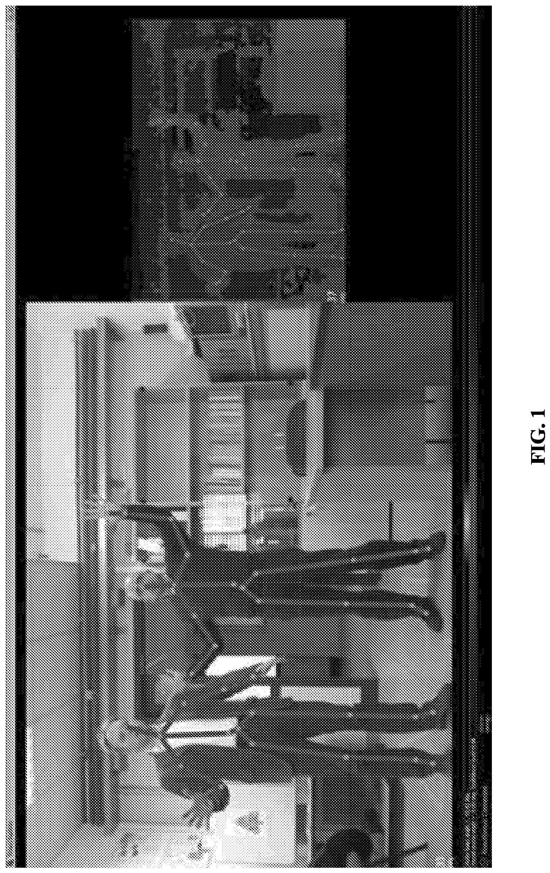

Reference will be made to the annexed Figure 1, showing, by way of example, two persons in the field of vision of a depth camera and the real-time reconstruction (10 fps) of a stick model of their bodies.

In general, the invention is based on techniques for singling out the position of staff inside the monitored premises (room) where the magnetic field-generating apparatus resides.

To this end, a method for monitoring the exposure of one or more subjects to a magnetic field (hereinafter identified by B) in an environment according to the present invention comprises first of all a step of detecting, over time, a spatial position of one or more subjects in the environment that is to be monitored.

Then, information on the position of each subject are integrated with information related to the magnetic field scattered inside the environment subjected to surveillance.

To this end, a spatial map of the magnetic field in the environment of interest is provided.

Then, for each detected position, it is extracted from the map a corresponding value of the magnetic field associated with the detected position.

Said values of magnetic field extracted over time are then processed to assess whether they exceed predetermined safety thresholds.

The subject's position is preferably measured at a high temporal resolution, e.g. by an optical system for singling out the position of the same subject.

For purposes of operativeness, it is preferably provided a step of automatic recognizing of the subjects present in the monitored environment. This for the purpose of allowing monitoring of values even in the presence of plural subjects in the same environment, individually for each of them.

Moreover, advantageously, the detecting of the spatial position of each of the subjects comprises, for each of them, a detection of a plurality of spatial positions related to corresponding predefined anatomical districts. In that sense, a preferred embodiment provides that the positions at least of head, chest, limbs be measured. However, it is to be understood that the method according to the present invention may be extended to any number of anatomical districts.

Correspondingly, the extracting from the map the values of magnetic field comprises one extraction of a plurality of values of magnetic field associated with said plurality of spatial positions. In other words, there will be extracted, over time, a specific value for each body district of which the position has been measured.

Of such extracted values of magnetic field, for each subject and for each anatomical district thereof, different processing modes can be provided.

In particular, their integral over time and/or their variation over time (dB/dt) can be calculated.

This information, differentiated for each body part, will be utilized to warn when preset threshold values are exceeded, and stored in an information system for each later analysis that may become necessary.

The spatial map of the magnetic field, provided for the implementation of the method, may be a vector map or a scalar map and must advantageously extend to all of the environment subjected to surveillance or to the fraction of it in which there are magnetic field values greater than a determined minimum threshold of interest.

A vector-type map defines in each point the three components of the magnetic field, whereas, in a scalar-type map, for each point the module of the magnetic field vector is defined.

Moreover, the processing can advantageously provide a step of computing the currents induced by the magnetic field in the individual body districts of each subject present in the monitored environment. In that sense, a vector map would entail the advantage of allowing a more precise calculation of currents induced in the body following motions.

The spatial density of the information regarding the magnetic field, and therefore the map resolution, can be arbitrary, but better results are obtained with high-density maps (e.g., at least one point every 30 cm, along each of the three directions of a system of Cartesian axes). In any case, the method according to the present invention can provide the possibility of obtaining a continuous map of values of magnetic field by properly interpolating available data on a discrete map, however initially sampled.

The present invention further addresses a system for monitoring the exposure of one or more subjects to a magnetic field in an environment, in particular suitable for implementing a method according to what described hereto.

Such a system comprises first of all means for detecting, over time, a spatial position of said subjects in the environment to be controlled.

System operation being provided even in the presence of a plurality of subjects in the same environment, the system can advantageously provide means for performing a recognizing of subjects inside the environment under observation.

For the recognizing of subjects, the system can integrate specific algorithms for face recognition from images, as well as the possibility of encoding information related to the identity of each person by optical codes to be placed on work overalls and capable of being detected and decoded by the position measuring system.

Alternatively, the recognizing can occur by distinct identification (ID) systems, for instance based on radiofrequency techniques providing transmitters for each person being admitted to the controlled area and a suitable sensor network capable of identifying the emitter and spatially localizing it so as to univocally carry out an association between the position data of each body and the ID data of the persons concomitantly present inside the monitored premises (room).

In another operation mode, useful when the persons having access to the monitored area are not a limited number of authorized persons but a larger group, identity recognizing can be not carried out and the system can limit itself to signal the sole exceeding of preset instantaneous limit values for the exposure to B and/or for induced currents (the latter related to the dB/dt value).

Therefore, for each subject present and recognized in the environment, there will be detected over time the spatial position in the environment to be controlled. This is possible, e.g., through software procedures adapted to implement person-tracking algorithms.

The method for recognizing and tracking, which should also enable the recognizing of the operator's various body districts, preferably operates through reconstruction of a numerical model of the subject's body, comprised of a stylized shape (the stylized model is merely an exemplification: other models, e.g., based on volume elements, such as cylinders, ellipsoids, etc, are to be considered as falling within the present invention) representing the essential body districts (merely by way of example, comprised of head, forearms and arms, chest, shins and thighs.

The model can be simplified or made more detailed by increasing the number of elements, though remaining within the specifications of the invention. The elements of the model are considered rigid bodies, anchored to each other, which can perform some rotations (some of them have a single axis of rotation, e.g. at the elbows or knees, others have two, like at the shoulders).

The numerical model is for associating the corresponding meaning with each recognized point. It is also useful to make the tracking operating quicker (the knowledge of the position of a certain point, combined with the motion constraints each associated rigid body possesses, allows to restrict the search for its position, at a later time, in a confined region of space). Therefore, the model serves to implement a rapid and effective recognition system of each body part, of its motion speed, and enables the assessment of its exposure to the magnetic field.

The system should preferably operate with no need of contact (by way of a non-exhaustive example, by the use of electromagnetic waves in the visible or infrared frequencies).

To this end, one or more sensors are advantageously provided for acquiring images of the subjects in the environment and obtaining their spatial positions in relation to a reference system.

It is to be understood that the images useful for the present invention, besides traditional images in the frequencies of the visible range, could also be images generated at a frequency outside the visible range, e.g. infrared or THz (body scanner) images.

Accordingly, the means for detecting the position could comprise sensors of various type, depending on the technology used.

Such sensors can, e.g., be cameras, installed in various positions of the environment so as to ensure that each point be monitored preferably by more than one of them.

The presence of these sensors ensures the possibility of calculating the position of an object or of a person wherever in the monitored area.

After installation of the abovementioned sensors, system calibration has to be provided for. Calibration is mainly for determining the mutual position/orientation of the sensors and establishing a single reference system.

Calibration moreover is for assessing and numerically reducing any distortion caused by the sensors. Since such operation depends on the type and grade/brand of sensor used and does not influence the inventive concept of the present invention, no discussion on it will be given in the following description.

The system according to the present invention further comprises a spatial map of the magnetic field in the environment. A mention of said map, of vector or scalar type, has already been given in the foregoing.

Of course, in all cases in which the magnetic field remains constant over time, it suffices that the magnetic field be measured only once and its spatial distribution stored. To obtain the map of B it is preferable to combine the measurement of the field, obtained by traditional magnetic field sensors, with position indications collected from the various position sensors installed in the room. This ensures that any distortions or position errors systematically produced by position sensors always affect in the same way each time the measurement of position of an object in the room is carried out (first time included).

Of course, other measurement/field distribution reconstruction procedures are to be considered possible according to the present invention; likewise, the system provides means for interpolating the values of the magnetic field in a discrete map, to obtain a continuous map.

The system will further comprise means for extracting from the map a corresponding value of the magnetic field associated with each detected position, and means for processing the values of the magnetic field extracted over time to assess whether they exceed predetermined safety thresholds.

The means for detecting the spatial position of the subjects is also adapted to detect, for each subject, a plurality of spatial positions related to corresponding predefined anatomical districts.

Correspondingly, the means for extracting from the map a value of magnetic field is adapted to extract, for each subject, a plurality of magnetic field values associated with the plurality of spatial positions.

This allows to detect the position of individual body districts of the subject under analysis, e.g., at least the head, torso and the individual limbs. Of course, also a higher detail may be provided.

The position of the individual districts can be obtained by a specially provided software that integrates the set of data related to the position of a subject in a numerical model schematizing the human anatomy.

The system can advantageously have a high degree of redundancy, so as to limit as much as possible blind zones that may prevent the reconstruction of the spatial position of the various districts of each person present in the area of interest.

The means for processing the values of the magnetic field is adapted to calculate, for each subject and for each anatomical district thereof, the integral over time and/or the variation over time and/or compute the currents induced by the magnetic field in the body of the subjects. The exposure is thus differentiated by anatomical districts and is analyzable in real time by the same system. In fact, the system checks that the values gradually reached be not higher than the maximum levels indicated by law or the reference values set by the person in charge of the surveillance (monitoring). The system is therefore capable of instantaneously providing assessments of exposure for the operator(s) present inside the monitored zone and of timely signalling any exceeding of the threshold limits.

Advantageously, the system can provide means for storing the values of the magnetic field, for any successive analysis.

It is understood that each processing provided according to the present invention could be performed by specially provided software means. This is true, e.g., for the processing of images in order to implement recognition and tracking algorithms, for the modeling of the person and of the anatomical districts of interest, for the algorithms of interpolation of the map of the magnetic field, for the processing of the values of the magnetic field extracted from the map, for the computing of the currents induced in each body district, etc.

Lastly, it is pointed out that the invention described herein is suitable for being used also in all those cases in which the magnetic field varies in strength over time, keeping however a certain spatial profile.

In these cases, the magnetic field can be described by a (vector or spatial) field of B(x,y,z,t)=Bt(t)*Bs(x,y,z) type.

Said situation occurs, e.g., in the cases in which the magnetic field is generated by an electromagnet whose current can be modulated as a function of time.

In this case, in order to know the field at every instant it is sufficient to know the function Bs(x,y,z) (related to a preset, arbitrary value of the current) in discrete points of the space, and obtain the quantity Bt(t) by a measurement of magnetic field to be performed in any one point of the monitored area. Thus, surveillance can be extended also to the case of magnetic fields variable over time, as long as these variations do not contain frequency values so high as to cause the conductive features of the human body to substantially modify the magnetic field inside the same, compared to the value measured in the same position in air. When this latter case does not occur, the proposed system can advantageously be utilized for monitoring the exposure and for determining the induced currents, on condition that for this latter quantity the linked flow variation, due to temporal variability of the magnetic field itself as much as to motion of subjects inside the monitored zone, be taken into account.

### Laboratory tests

Tests were conducted; their results, achieved with a depth camera of RGB-Depth type (exploiting triangulation) and a suitable tracking algorithm for the human body are reported by way of illustration.

The technique adopted consists in a tracking algorithm of markerless type for tracking the position of each body part *[*L.A. Schwarz, A. Mkhitaryan, D. Mateus, N. Navab, Human skeleton tracking from depth data using geodesic distances and optical flow. Image Vision Comput. 30(3): 217-226 (2012*);* L.A. Schwarz, D. Mateus, N. Navab, Recognizing multiple human activities and tracking full-body pose in unconstrained environments, Pattern Recognition 45(1): 11-23 (2012*);* L.A. Schwarz, A. Mkhitaryan, D. Mateus, N. Navab: Estimating human 3D pose from Time-of-Flight images based on geodesic distances and optical flow, FG 2011: 700-706*],* but also typologies of marker-based-type algorithms *[*T.B. Moeslund, A. Hilton, V. Kruger, A survey of advances in vision-based human motion capture and analysis, Computer Vision and Image Understanding 104 (2006) 90-126*;* D.Franchi, A.Maurizi, and G.Placidi, Characterization of a SimMechanics Model for a Virtual Glove Rehabilitation System, Lecture Notes in Computer Science (6026), 141-150 (2010*);* D.Franchi, A.Maurizi, G.Placidi, A Numerical Hand Model for a Virtual Glove Rehabilitation System, Proc. of the IEEE Med. Meas. & Appl., MeMeA 2009, 1, 41-44 (2009*)]* have to be considered equally encompassed by the present invention.

Figure 1 illustrates the system capability of automatically performing person recognition in the frame (even when in a number greater than one) and the modeling of the body of each person according to a stick model. Spatial localization of the stick model is a direct consequence of the use of a depth camera.

Takes were processed in real time on a conventional computer, using a tracking algorithm for the human body. The results are very promising and rather accurate (temporal resolution of 10 fps, spatial resolution: 6 cm at a 4-meter with a RGB-Depth camera, called Kinect, from Microsoft).

Then, the use of two depth cameras, installed at opposed positions on two of the top corners of the room, was tested. The two cameras were calibrated by using triangulation methods on points singled out on a geometric model of known shape and size (a chessboard, taken from various positions and angles). The possibility of synchronizing the takes of the two cameras and of obtaining from each camera the same spatial localization of the objects was demonstrated.

The present invention has hereto been described with reference to preferred embodiments thereof. It is understood that each of the technical solutions implemented in the preferred embodiments, described herein by way of example, could advantageously be differently combined with each other, to give shape to other embodiments, all falling within the concept of the same invention and all anyhow comprised within the protective scope of the claims hereinafter.

## Claims

1. Method for monitoring the exposure of one or more subjects to a magnetic field in an environment, comprising the steps of:
- providing a spatial map of the components of said magnetic field in said environment;
- detecting, over time, a spatial position of said one or more subjects in said environment; and,
- **characterised by** extracting for each detected position from said map a corresponding value of the magnetic field associated with said detected position; and
- processing said values of magnetic field extracted over time to assess whether they exceed predetermined safety thresholds.

2. Method according to claim 1, comprising a step of recognizing said one or more subjects when they are inside said environment.

3. Method according to claim 1 or 2, wherein said step of detecting a spatial position of said one or more subjects comprises, for each subject, a detection of a plurality of spatial positions related to corresponding predefined anatomical districts and said step of extracting from said map a value of magnetic field comprises, for each subject, one extraction of a plurality of magnetic field values associated with said plurality of spatial positions.

4. Method according to anyone of the preceding claims, wherein said step of processing the values of the magnetic field comprises a step of calculating their integral over time.

5. Method according to anyone of the preceding claims, wherein said step of processing the values of the magnetic field comprises a step of calculating their variation over time.

6. Method according to anyone of the preceding claims, wherein said step of processing the values of the magnetic field comprises a step of computing the currents induced by the magnetic field in the body of said subject.

7. A system for monitoring the exposure of one or more subjects to a magnetic field in an environment, comprising
- a spatial map of said magnetic field in said environment;
- means for detecting, over time, a spatial position of said one or more subjects in said environment; **characterised by**
- means for extracting from said map a corresponding value of the magnetic field associated with each detected position; and
- means for processing said values of magnetic field extracted over time to assess whether they exceed predetermined safety thresholds.

8. A system according to claim 7, comprising means for performing an initial detection of said one or more subjects when they are inside said environment.

9. A system according to claim 7 or 8, wherein said means for detecting a spatial position of said one or more subjects is adapted to detect, for each subject, a plurality of spatial positions related to corresponding predefined anatomical districts and said means for extracting from said map a value of magnetic field is adapted to extract, for each subject, a plurality of magnetic field values associated with said plurality of spatial positions.

10. System according to anyone of claims 7 to 9, wherein said means for processing the values of the magnetic field is adapted to calculate their integral over time.

11. System according to any one of claims 7 to 10, wherein said means for processing the values of the magnetic field is adapted to calculate their variation over time.

12. System according to any one of claims 7 to 11, wherein said means for processing the values of the magnetic field is adapted to calculate the currents induced by the magnetic field in the body of said subject.

13. System according to anyone of claims 7 to 12, wherein said means for detecting, over time, a spatial position comprises one or more sensors for obtaining spatial positions of said subjects in said environment, in relation to a reference system.

14. A system according to claim 13, wherein said one or more sensors comprise at least one camera for acquiring images of said subjects.

15. System according to anyone of claims 7 to 14, wherein said means for detecting, over time, a spatial position comprises one or more tracking algorithms.

## Patentansprüche

1. Verfahren zum Überwachen der Aussetzung von einem oder mehreren Subjekten gegenüber einem magnetischen Feld in einer Umgebung, welches die folgenden Schritte umfasst:
- Bereitstellen einer räumlichen Abbildung der Komponenten des magnetischen Feldes in der Umgebung;
- Erfassen, über die Zeit, einer räumlichen Position des einen oder der mehreren Subjekte in der Umgebung; und
- **gekennzeichnet durch** Extrahieren für jede erfasste Position aus der Abbildung eines entsprechenden Wertes des magnetischen Feldes, der mit der erfassten Position assoziiert ist; und
- Verarbeiten der Werte des magnetischen Feldes, die über die Zeit extrahiert wurden, um einzuschätzen, ob sie vorbestimmte Sicherheitsschwellen überschreiten.

2. Verfahren nach Anspruch 1, das einen Schritt zum Erkennen des einen oder der mehreren Subjekte umfasst, wenn sie sich innerhalb der Umgebung befinden.

3. Verfahren nach Anspruch 1 oder 2, wobei der Schritt zum Erfassen einer räumlichen Position des einen oder der mehreren Subjekte für jedes Subjekt eine Erfassung einer Vielzahl räumlicher Positionen umfasst, die mit entsprechenden vordefinierten anatomischen Bereichen in Verbindung stehen, und wobei der Schritt zum Extrahieren eines Wertes des magnetischen Feldes aus der Abbildung für jedes Subjekt eine Extraktion einer Vielzahl von magnetischen Feldwerten umfasst, die mit der Vielzahl räumlicher Positionen assoziiert sind.

4. Verfahren nach einem der vorhergehenden Ansprüche, wobei der Schritt zum Verarbeiten der Werte des magnetischen Feldes einen Schritt zum Berechnen ihres Integrals über die Zeit umfasst.

5. Verfahren nach einem der vorhergehenden Ansprüche, wobei der Schritt zum Verarbeiten der Werte des magnetischen Feldes einen Schritt zum Berechnen ihrer zeitlichen Veränderung umfasst.

6. Verfahren nach einem der vorhergehenden Ansprüche, wobei der Schritt zum Verarbeiten der Werte des magnetischen Feldes einen Schritt zum Berechnen der Ströme umfasst, die durch das magnetische Feld im Körper des Subjekts induziert werden.

7. System zum Überwachen der Aussetzung von einem oder mehreren Subjekten gegenüber einem magnetischen Feld in einer Umgebung, umfassend
- eine räumliche Abbildung des magnetischen Feldes in der Umgebung;
- Mittel zum Erfassen, über die Zeit, einer räumlichen Position des einen oder der mehreren Subjekte in der Umgebung; **gekennzeichnet durch**
- Mittel zum Extrahieren aus der Abbildung eines entsprechenden Wertes des magnetischen Feldes, der mit jeder erfassten Position assoziiert ist; und
- Mittel zum Verarbeiten der Werte des magnetischen Feldes, die über die Zeit extrahiert wurden, um einzuschätzen, ob sie vorbestimmte Sicherheitsschwellen überschreiten.

8. System nach Anspruch 7, das Mittel zum Ausführen einer Initialerfassung des einen oder der mehreren Subjekte umfasst, wenn sie sich in der Umgebung befinden.

9. System nach Anspruch 7 oder 8, wobei die Mittel zum Erfassen einer räumlichen Position des einen oder der mehreren Subjekte geeignet sind, für jedes Subjekt eine Vielzahl räumlicher Positionen zu erfassen, die mit vordefinierten anatomischen Bereichen korrespondieren, und wobei die Mittel zum Extrahieren aus der Abbildung eines Wertes des magnetischen Feldes geeignet sind, für jedes Subjekt eine Vielzahl magnetischer Feldwerte zu extrahieren, die mit der Vielzahl von räumlichen Positionen assoziiert sind.

10. System nach einem der Ansprüche 7 bis 9, wobei die Mittel zum Verarbeiten der Werte des magnetischen Feldes geeignet sind, ihr Integral über die Zeit zu berechnen.

11. System nach einem der Ansprüche 7 bis 10, wobei die Mittel zum Verarbeiten der Werte des magnetischen Feldes geeignet sind, ihre zeitliche Veränderung zu berechnen.

12. System nach einem der Ansprüche 7 bis 11, wobei die Mittel zum Verarbeiten der Werte des magnetischen Feldes geeignet sind, die Ströme zu berechnen, die durch das magnetische Feld in dem Körper des Subjekts induziert werden.

13. System nach einem der Ansprüche 7 bis 12, wobei die Mittel zum zeitlichen Erfassen einer räumlichen Position ein oder mehrere Sensoren zum Erhalten räumlicher Positionen der Subjekte in der Umgebung in Bezug auf ein Bezugssystem umfassen.

14. System nach Anspruch 13, wobei der eine oder die mehreren Sensoren wenigstens eine Kamera zum Aufnehmen von Bildern der Subjekte umfassen.

15. System nach einem der Ansprüche 7 bis 14, wobei die Mittel zum zeitlichen Erfassen einer räumlichen Position ein oder mehrere Verfolgungsalgorithmen umfassen.

## Revendications

1. Procédé pour surveiller l'exposition d'un ou de plusieurs sujets à un champ magnétique dans un milieu environnant, comprenant les étapes consistant à :
- fournir une carte spatiale des composantes dudit champ magnétique dans ledit milieu environnant ;
- détecter, dans le temps, une position spatiale desdits un ou plusieurs sujets dans ledit milieu environnant ; et,
- **caractérisé par** l'extraction, pour chaque position détectée à partir de ladite carte, d'une valeur correspondante du champ magnétique associée à ladite position détectée ; et
- traiter lesdites valeurs de champ magnétique extraites dans le temps pour évaluer si elles dépassent des seuils de sécurité prédéterminés.

2. Procédé selon la revendication 1, comprenant une étape consistant à reconnaître lesdits un ou plusieurs sujets lorsqu'ils se trouvent à l'intérieur dudit milieu environnant.

3. Procédé selon la revendication 1 ou 2, dans lequel ladite étape consistant à détecter une position spatiale desdits un ou plusieurs sujets comprend, pour chaque sujet, une détection d'une pluralité de positions spatiales liées à des régions anatomiques prédéfinies correspondantes, et ladite étape consistant à extraire à partir de ladite carte une valeur de champ magnétique comprend, pour chaque sujet, une extraction d'une pluralité de valeurs de champ magnétique associées à ladite pluralité de positions spatiales.

4. Procédé selon l'une quelconque des revendications précédentes, dans lequel ladite étape consistant à traiter les valeurs du champ magnétique comprend une étape consistant à calculer leur intégrale dans le temps.

5. Procédé selon l'une quelconque des revendications précédentes, dans lequel ladite étape consistant à traiter les valeurs du champ magnétique comprend une étape consistant à calculer leur variation dans le temps.

6. Procédé selon l'une quelconque des revendications précédentes, dans lequel ladite étape consistant à traiter les valeurs du champ magnétique comprend une étape consistant à calculer les courants induits par le champ magnétique dans le corps dudit sujet.

7. Système pour surveiller l'exposition d'un ou de plusieurs sujets à un champ magnétique dans un milieu environnant, comprenant
- une carte spatiale dudit champ magnétique dans ledit milieu environnant ;
- un moyen pour détecter, dans le temps, une position spatiale desdits un ou plusieurs sujets dans ledit milieu environnant ; **caractérisé par**
- un moyen pour extraire à partir de ladite carte une valeur correspondante du champ magnétique associée à chaque position détectée ; et
- un moyen pour traiter lesdites valeurs de champ magnétique extraites dans le temps pour évaluer si elles dépassent des seuils de sécurité prédéterminés.

8. Système selon la revendication 7, comprenant un moyen pour effectuer une détection initiale desdits un ou plusieurs sujets lorsqu'ils se trouvent à l'intérieur dudit milieu environnant.

9. Système selon la revendication 7 ou 8, dans lequel ledit moyen pour détecter une position spatiale desdits un ou plusieurs sujets est adapté pour détecter, pour chaque sujet, une pluralité de positions spatiales liées à des régions anatomiques prédéfinies correspondantes, et ledit moyen pour extraire à partir de ladite carte une valeur de champ magnétique est adapté pour extraire, pour chaque sujet, une pluralité de valeurs de champ magnétique associées à ladite pluralité de positions spatiales.

10. Système selon l'une quelconque des revendications 7 à 9, dans lequel ledit moyen pour traiter les valeurs du champ magnétique est adapté pour calculer leur intégrale dans le temps.

11. Système selon l'une quelconque des revendications 7 à 10, dans lequel ledit moyen pour traiter les valeurs du champ magnétique est adapté pour calculer leur variation dans le temps.

12. Système selon l'une quelconque des revendications 7 à 11, dans lequel ledit moyen pour traiter les valeurs du champ magnétique est adapté pour calculer les courants induits par le champ magnétique dans le corps dudit sujet.

13. Système selon l'une quelconque des revendications 7 à 12, dans lequel ledit moyen pour détecter, dans le temps, une position spatiale comprend un ou plusieurs capteurs pour obtenir des positions spatiales desdits sujets dans ledit milieu environnant, par rapport à un système de référence.

14. Système selon la revendication 13, dans lequel lesdits un ou plusieurs capteurs comprennent au moins une caméra pour acquérir des images desdits sujets.

15. Système selon l'une quelconque des revendications 7 à 14, dans lequel ledit moyen pour détecter, dans le temps, une position spatiale comprend un ou plusieurs algorithmes de suivi.
